Europäisches Patentamt

European Patent Office

Office européen des brevets

(11) Publication number : **0 500 235 A1**

# (12) EUROPEAN PATENT APPLICATION

(21) Application number : 92301005.2

(22) Date of filing : 06.02.92

(51) Int. Cl.⁵ : **H01L 21/48**

(30) Priority : **14.02.91 US 655883**

(43) Date of publication of application :
**26.08.92 Bulletin 92/35**

(84) Designated Contracting States :
**DE FR GB**

(71) Applicant : **International Business Machines
Corporation
Old Orchard Road
Armonk, N.Y. 10504 (US)**

(72) Inventor : **Puligandla, Viswanadham
2147 Surrender Avenue
Austin, Texas 78758 (US)**
Inventor : **Vasan, Srini Varadarajan
12001 North Oaks Drive
Austin, Texas 78753 (US)**

(74) Representative : **Killgren, Neil Arthur
IBM United Kingdom Limited Intellectual
Property Department Hursley Park
Winchester Hampshire SO21 2JN (GB)**

(54) **Protecting tape automated bonding devices.**

(57)  The copper fan out circuitry (6) on the underside of a tape automated bonding (TAB) device (3) is coated with an electrically non-conductive organic polymer (60) to provide mechanical rigidity and environmental protection to the device.

FIG. 8

EP 0 500 235 A1

The present invention relates to electronic packaging. More particularly the invention relates to packaging components on flexible module carriers referred to as Tape Automated Bonding (TAB) Devices, where the semiconductor devices are on two layer or three layer flexible tapes made of such materials as polyimide.

Surface mount devices are typically manufactured in plastic packages. Functional semiconductor chip terminals are connected to lead frames through wire bonding. The lead frames and the chip are in turn encapsulated in a moulding compound and cured, thus resulting in a rigid package with leads capable of being formed to desired shapes. Such a package thus is protected from environmental, mechanical, and electrostatic damage.

With increasing package densities lead pitches have migrated from 0.050 to less than 0.020 inches, and flexible module carriers made of polyimide have been developed. Copper lead frame circuitry is delineated by photolithographic and electroplating processes. Two layer tapes comprised of polyimide and copper with a thin chromium adhesion layer have come into use.

Such tapes are conventionally handled in reel to reel form by tape manufacturers, first level packagers for attachment of chip to the tape, and by second level packagers. As is customarily known in the electronic industry the process of assembling surface mount and pin through hole electronic components onto the printed circuit board is referred to as second level electronic packaging. For second level TAB packaging, individual modules are excised, their leads formed to a desired configuration, and interconnection to a printed circuit board is effected. The outer leads provide nominally 0.030 inch standoff by virtue of the lead forming operation.

However, circuitry on the underside of the tape is left exposed. Signal circuitry is susceptible to electrical shorting due to inadvertent pressing of a device against power or ground via holes on a card. Corrosion, electromigration, and delamination from the polyimide are also possible deleterious events. More importantly, two layer tape is physically less rigid; and hence, much more flexible than three layer tape structures sometimes used.

Two layer tape frequently exhibits flatness nonuniformities to varying degrees in the form of tape curl, waviness, canoeing, and twist. The extent of these nonplanarities are dependent inter alia, on moisture content of the tape, reel diameter at the location of a particular module, and the history of the tape itself.

Module pickup tools may be vacuum devices which are very sensitive to planarity effects in their performance.

Nonplanarity therefore introduces uncertainties into the operation of device pick and place machines causing throughput concerns, yield losses, and ultimately increases in assembly cost.

Additionally, processing chemicals in the fabrication of these TAB packages sometimes leave behind traces of corrosive elements such halide ions, or other elements within the tape material. When the assemblies are operated under applied voltage and in above ambient temperature and humidity environments the contaminants lead to electromigration and corrosion, thus weakening the adhesion between the copper and the polyimide.

These problems have hitherto been addressed by the use of three layer tape, the use of totally different pick and place machinery, and total encapsulation of the TAB module. Three layer tape is expensive owing to the number of process steps involved in its fabrication. Pick and place apparatus becomes more complex and expensive if it is to handle irregularities in TAB tape planarity. The last options add complexity to rework and repair operations. Therefore, such options are not considered effective in obtaining a reasonable solution to TAB tape curling and associated problems.

According to the invention there is provided a method of treating a flexible circuitised carrier bearing electronic devices to provide mechanical rigidity and environmental protection comprising: applying an electrically nonconductive coating to a thickness of from about .001 inches to about .003 inches over selected portions of said circuitized carrier.

There is further provided apparatus for treating individual TAB device frames on a continuous flexible tape comprising a coating station having a support for retaining a TAB frame during coating; means at said coating station for depositing a protective polymeric coating on exposed circuitry on said TAB frame and advancing means for indexing said tape to and past said coating station.

Suitable commercially available polymeric materials include polyimides, acrylics, and unfilled or filled epoxy compositions. While encapsulation of the entire device after excise, form, and outer lead bonding on to the substrate is described in the prior art, the present invention relates to reel to reel processing of TAB device tape and the application to one side thereof, of a protective coating after inner lead bonding, and chip encapsulation. Composition 32 or 50 is chosen from polyimides, acrylics or epoxy compositions.

The coating provides additional mechanical rigidity and increased dimensional stability in terms of planarity. Covering the underside of TAB modules with polymeric film provides a mechanical barrier to any corrosive elements that the module may encounter during second level assembly operations, thus preventing corrosion and electromigration phenomenon deleterious to the functional characteristics of the device. Also, our protective coating constitutes a physical barrier to moisture ingress and thereby enhances the adhesion characteristics of the different layers, hence significantly reducing delamination.

The protective coating is applied as a thin layer in the range of a few thousandths of an inch on the circuit side of the tape after covering the inner lead bonding and the chip areas with a suitable encapsulant material, using what is known as "glob top" encapsulant. Application of a protective layer on the circuit side of a two layer tape provides adequate rigidity to the device and ensures prevention of materials degradation.

Brief Description of the Drawing

The above and other features and advantages of the present invention will become clearer as this description continues, having reference to the drawing wherein like numerals are used to denote like parts throughout and wherein:

Fig. 1 shows a portion of one frame of a reel of TAB devices.

Fig. 2 is a schematic cross-section of a prior art TAB device after assembly.

Fig. 3 schematically illustrates apparatus for applying a coating in accordance with the present invention.

Fig. 4 shows in enlarged detail apparatus for practicing the present invention.

Fig. 5 is an enlarged schematic of nozzle 30 in Fig. 4.

Fig. 6 is a cross-sectional view of apparatus for screening the coating material in accordance with the present invention.

Fig. 7 is a planar view of screen 52 in Fig. 6.

Fig. 8 is a schematic cross-sectional view of a coated TAB device after assembly.

Description of Preferred Embodiments

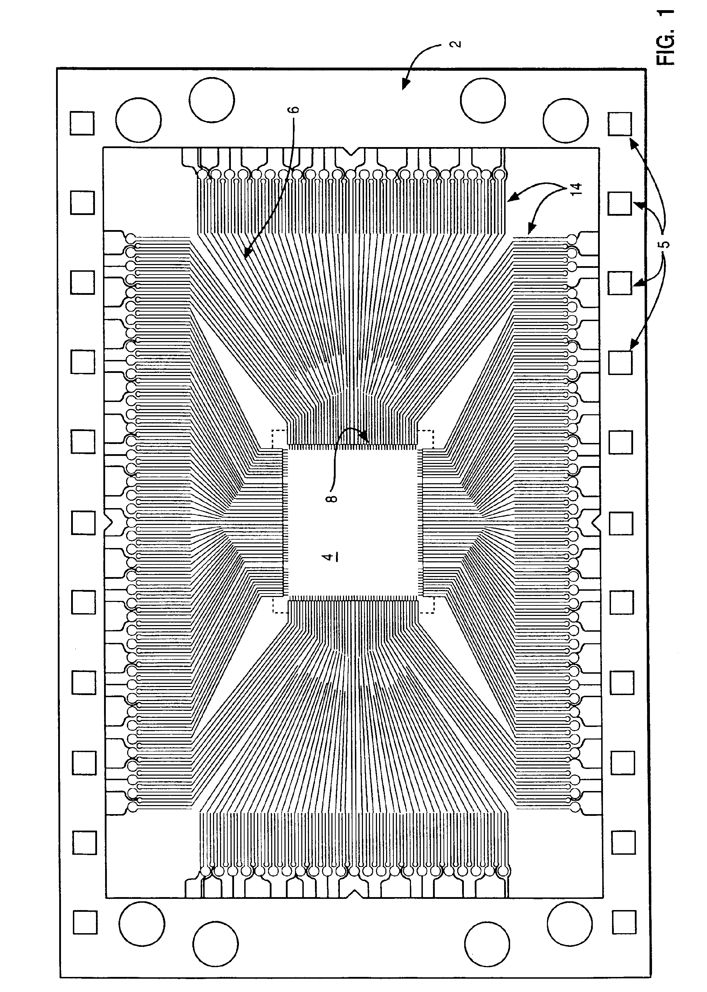

Refer now to Fig. 1 which shows a single frame 2 of TAB tape, including an electronic device 4 mounted thereon from a reel of tape before an excise and form operation. As is well known, TAB tape is provided with sprocket holes 5. Circuit lines 6 emanate from inner lead bond (ILB) area 8.

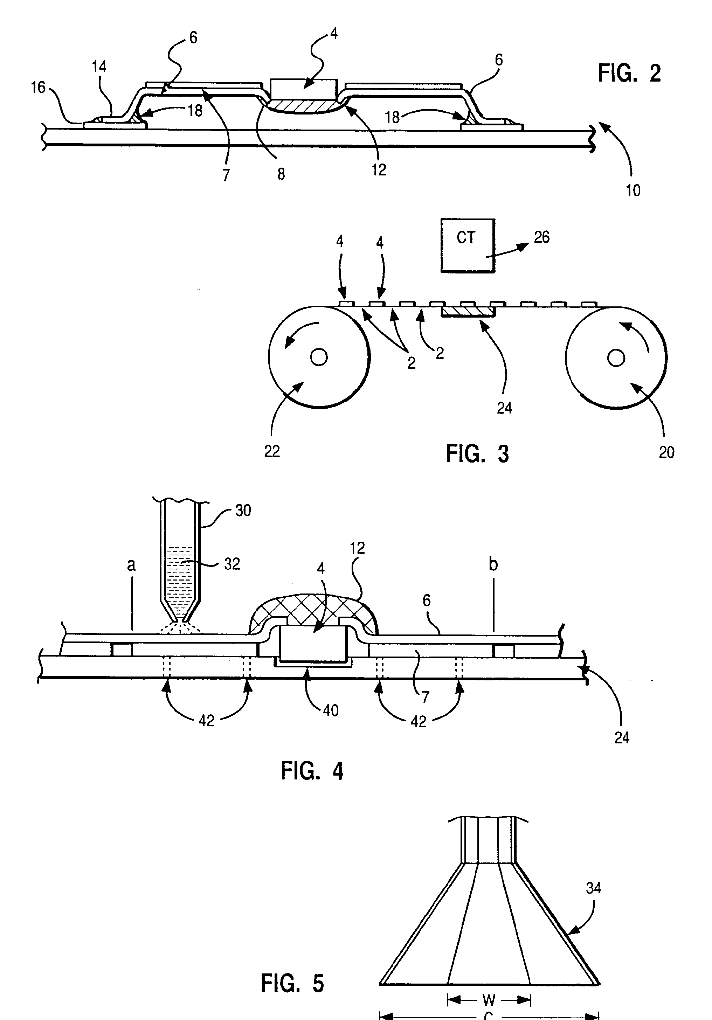

Fig. 2 shows a sectional view of device frame 2, Fig. 1, bonded to a printed circuit substrate 10. Silicon chip 4 is bonded to tape 2 at bond area, ILB area 8. A suitable encapsulant 12, such as a silicone or epoxy, covers chip 4. Copper circuitry 6 fans out to form outer leads 14. As is well understood in the art, tape 2 is 35 mm wide and is available on a reel from which individual frames are subsequently excised and formed prior to bonding to pads 16 on substrate 10 using, for example, hot bar solder reflow techniques to effect formation of solder joint 18.

Fig. 3 is a schematic diagram of apparatus for practicing the present invention. A plurality of TAB devices 2 are advanced from reel 20 to reel 22 past a coating station comprising support member 24 and coating tool 26. Conventional means for indexing through engagement of sprocket holes 'S' may be used. Takeup reel 22 is indexed to move the next sequential frame 2 to coating station which may comprise different types of dispensing or coating tools, depending on the choice of coating material.

Coating tool 26 may preferably comprise a spray coater such as is commercially available as Zycon Series 10000 Lab Coater operating at air pressures in the vicinity of 50 PSIG for coating materials such as filled epoxies. Less viscous materials such as acrylics may be applied using a tool such as commercially available Nordson Select Coat Dispenser. Either of these tools may be interconnected with computer control for facilitating automation of the process, including at least the steps of starting, dispensing and stopping. Obviously such processes are designed to suit particular tape/chip combination.

Refer now to Fig. 4. Preferably the coating tool portion of our apparatus comprises a programmable translatable nozzle 30 adapted for dispensing a polymeric protective composition 32. Composition 32 is chosen from polyimides, acrylics or epoxy compositions. Polyimides are a group of thermosetting ring chain polymers that are imidized from polyamic acid at appropriate temperatures to initiate and complete imide ring closure. Acrylics are thermoplastics such as polymethyl methacrylates in organic solvents such as toluene, ethyl benzene, ketones etc. Epoxies are thermosetting polymers of resin-hardeners cross linked network systems with bisphenol A and epichlorohydrin and related compounds. Filler materials for these epoxies are inert substances and include such materials as zinc oxide to the extent of 50 to 70% by weight as described elsewhere in commonly assigned copending U.S. Application S/N 07/267,406 (IBM Docket EN9-87-046).

Nozzle 30 includes an outlet portion 34. Nozzle 30 is constructed to dispense material 32 at a predetermined volumetric flow rate beginning at point 'a'. Material flow is interrupted at a predetermined point in advance of chip 4 and flow resumes immediately after nozzle 30 has passed over chip 4 and continues to point 'b' so as to coat those portions previously indicated in connection with the description of Fig. 1.

During the coating process tape 2 is maintained stationary on support 24. Support 24 includes recessed area 40 for accommodating a given chip 4. Support 24 is likewise provided with vacuum ports 42 connected appropriately for maintaining planarity of the TAB device frame 2 during the coating operation.

Fig. 5 shows in greater detail the outlet portion 34 of nozzle 30 of Fig. 4. The total width of the nozzle outlet 34 is C. Coating material flows through all segments of the nozzle until it reaches the chip 4 at which time flow through segment W is interrupted. Flow through segment W is resumed once the nozzle is past the chip.

In a particular application of the present invention, total nozzle travel length is 35 mm with a 20 mm wide span and 1 cm x 1 cm chip 4 with glob top coating 12 protruding a maximum of 2 mm above the surface of frame 2. Materials such as epoxies, acrylics and polyimides, it has been found, may be cured using radiation or thermal means. Coating to a thickness in a range of about .001″ to about .003″ has been found adequate for most applications. The epoxy material may be cured by exposure to a temperature of about 120 deg. C for about 30 minutes.

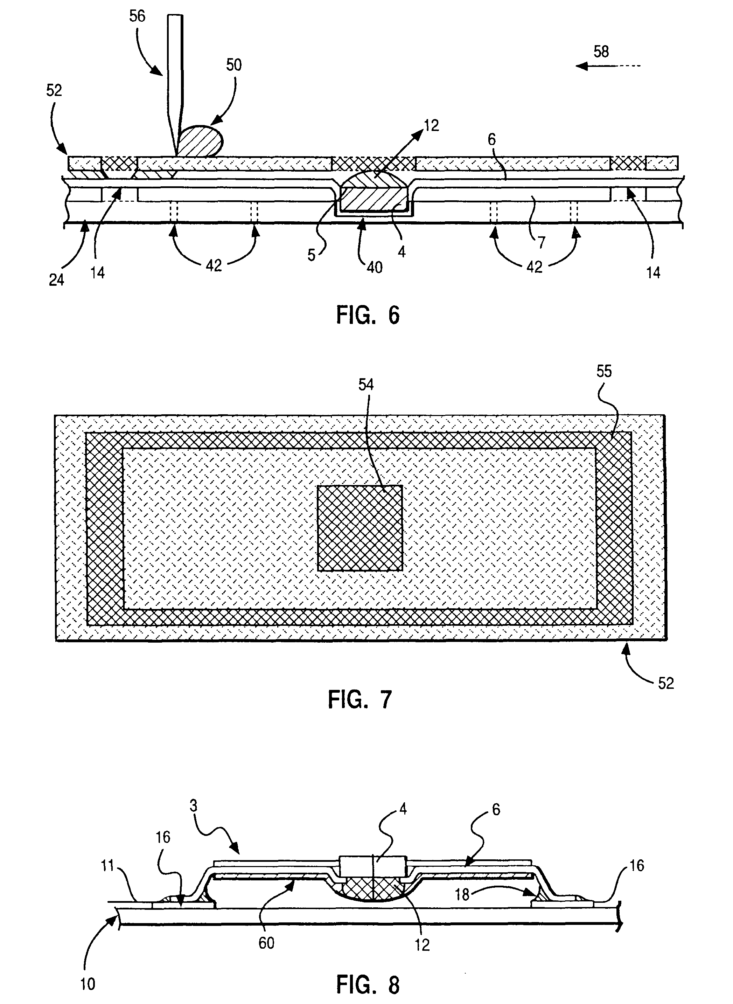

Refer now to Fig. 6 which is a cross-sectional view of another embodiment of the present invention. In this embodiment a coating material 50 is applied through a screen 52 to the underside of TAB frame 2. Screen 52 shown in plan view in Fig. 7 is designed to isolate the area corresponding to chip 4 as well as the outer lead bond (OLB) 14 and sprocket holes 'S' (Fig.1). Those spreckled portions of screen 52 are permeable to coating material 50 while crosshatched sections 54 and 55 prevent passage therethrough.

A squeegee 56 of conventional design is utilised for spreading material 50 which may be a filled epoxy. The mesh size of screen 52 is chosen as a function of the particle size of the filler material in the coating material 50 matrix. A 325 size mesh is suitable for a particle size distribution of from about 1 to about 10 micrometers and an epoxy matrix of the viscosity in the range of from about 6500 to about 22,500 CPS.

After passage of squeegee 56 across screen 52, screen 52 is lifted and frame 2 moves in the direction of arrow 58, allowing the next frame to be screened to be positioned under the screen that is between coating tool 26 and support 24 (Fig. 3). Thermal curing of such coatings at a temperature of about 120 deg. for about 30 minutes is suitable.

The above described two embodiments disclosing two methods of application provide a protective coating on the circuit side of TAB devices for eliminating the problem of tape curl and minimising problems related to flux and solder spatter during second level assembly to a printed circuit board while concurrently enhancing mechanical rigidity of the device.

Fig. 8 shows a cross-sectional schematic view of a TAB device coated in accordance with the present invention after it is excised, formed, and bonded to a printed circuit board. The protective coating 60 has been found to enhance adhesion of copper circuitry to polyimide by minimising the possibility of moisture ingress to the polyimide and thereby reducing potential for tape delamination.

Further, the protective coating provided in accordance with our invention makes TAB devices more amenable to handling in a reel to reel mode, including shipment after coating.

While the present invention has been described having reference to particular embodiments, those having skill in the art will appreciate that the above and other changes in form and detail may be made without departing from the spirit of the present invention as claimed.

## Claims

1. A method of treating a flexible circuitised carrier bearing electronic devices to provide mechanical rigidity and environmental protection comprising:
   applying an electrically nonconductive coating to a thickness of from about .001 inches to about .003 inches over selected portions of said circuitized carrier.

2. A method as in Claim 1 wherein said electrically nonconductive coating is an organic polymer chosen from epoxies, acrylics and polyimides.

3. A method as in Claim 1 wherein said applying step comprises spraying from a programmable, translatable nozzle.

4. A method as in Claim 1 wherein said applying step comprises screening through a mask having a pattern adapted for exposing said selected portions of said circuitized carrier.

5. A circuitised carrier produced by a method as claimed in any of claims to 4.

6. Apparatus for treating individual TAB device frames on a continuous flexible tape comprising
   a coating station having a support for retaining a TAB frame during coating;
   means at said coating station for depositing a protective polymeric coating on exposed circuitry on said TAB frame and
   advancing means for indexing said tape to and past said coating station.

7. The apparatus of Claim 6 wherein said means for depositing includes a programmable, translatable nozzle connectable to a supply of coating material, adapted for lateral movement and selective operation for spraying coating material only on said exposed circuitry.

8. The apparatus of Claim 6 wherein said means for depositing comprises:
   a screening mask permeable to said protective coating in areas corresponding to said exposed circuitry; and
   a squeegee means adapted for relative lateral motion with said mask, for spreading said protective coating therethrough.

9. The apparatus of Claim 7 wherein said protective polymeric coating is chosen from a group consisting of polyimides, acrylic thermoplastics and epoxy thermosetting polymers.

10. The apparatus of Claim 8 wherein said protective polymeric coating is chosen from a group consisting of having a particle size from about 1 to about 10 micrometers and a viscosity in a range of from about 6500 to about 22,500 CPS.

FIG. 1

FIG. 2

FIG. 3

FIG. 4

FIG. 5

7

FIG. 6

FIG. 7

FIG. 8

**European Patent Office**

# EUROPEAN SEARCH REPORT

Application Number

EP 92 30 1005

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | IBM TECHNICAL DISCLOSURE BULLETIN. vol. 33, no. 6B, November 1990, NEW YORK US pages 266 - 267; 'Protective coating process for thin film processes' | 1 | H01L21/48 |
| A | | 2,3,5 | |
| Y | EP-A-0 072 673 (MINNESOTA MINING AND MANUFACTURING COMPANY) * page 7, line 7 - line 12; claims 1,8,9 * | 1 | |
| A | | 2,5 | |
| A | WO-A-9 015 438 (UNISTRUCTURE) * page 6, line 25 - line 29 * * page 8, line 32 - line 34; claims 1,11 * | 1,2,5 | |
| | | | TECHNICAL FIELDS SEARCHED (Int. Cl.5 ) |
| | | | H01L |

The present search report has been drawn up for all claims

| Place of search | Date of completion of the search | Examiner |
|---|---|---|
| THE HAGUE | 10 JUNE 1992 | DE RAEVE R.A.L. |

EPO FORM 1503 03.82 (P0401)